(19) Europäisches Patentamt
European Patent Office
Office européen des brevets

(11) **EP 1 837 922 A1**

(12) **EUROPEAN PATENT APPLICATION**
published in accordance with Art. 158(3) EPC

(43) Date of publication:
**26.09.2007 Bulletin 2007/39**

(51) Int Cl.:
**H01L 33/00** (2006.01)

(21) Application number: **05820163.3**

(22) Date of filing: **26.12.2005**

(86) International application number:
**PCT/JP2005/023760**

(87) International publication number:
**WO 2006/075511 (20.07.2006 Gazette 2006/29)**

(84) Designated Contracting States:
**DE FR GB**

(30) Priority: **11.01.2005 JP 2005003436**

(71) Applicant: **Sony Corporation**
**Minato-ku**
**Tokyo (JP)**

(72) Inventors:
• **OKUYAMA, Hiroyuki**
**c/o Sony Corporation**
**Tokyo (JP)**

• **BIWA, Goshi**
**c/o Sony corporation**
**Tokyo (JP)**

(74) Representative: **Müller - Hoffmann & Partner**
**Patentanwälte,**
**Innere Wiener Strasse 17**
**81667 München (DE)**

(54) **GaN-BASED SEMICONDUCTOR LIGHT-EMITTING ELEMENT AND METHOD FOR FABRICATING SAME**

(57) A GaN-based semiconductor light-emitting element capable of suppressing the occurrence of piezoelectric spontaneous polarization in the thickness direction of an active layer and reducing the driving voltage of a light-emitting diode is provided. The GaN-based semiconductor light-emitting element has a structure with a first GaN-based compound semiconductor layer 21 having the top face parallel to the a-plane and having a first conductivity type, an active layer 22 having the top face parallel to the a-plane, a second GaN-based compound semiconductor layer 23 having the top face parallel to the a-plane and having a second conductivity type, and a contact layer 24 composed of a GaN-based compound semiconductor and having the top face parallel to the a-plane, stacked in that order. The GaN-based semiconductor light-emitting element further includes a first electrode 25 disposed on the first GaN-based compound semiconductor layer 21 and a second electrode 26 disposed on the contact layer 24.

FIG. 1

**Description**

Technical Field

The present invention relates to a GaN-based semiconductor light-emitting element and a method for producing the same.

Background Art

For example, in the case of blue or green light-emitting diodes (LEDs) each including an n-type GaN layer, an active layer composed of InGaN, and a p-type GaN layer, the layers being stacked, the lattice constant of an InGaN crystal is slightly larger than that of a GaN crystal. Thus, when the n-type GaN layer with the top face parallel to the c-plane, the active layer that is composed of InGaN and in which the top face is parallel to the c-plane, and the p-type GaN layer with the top face parallel to the c-plane are stacked, the active layer is subjected to compression pressure. As a result, piezoelectric spontaneous polarization occurs in the thickness direction of the active layer, causing phenomena such as a shift in the wavelength of light emitted from such a light-emitting diode, an increase in operating voltage, a decrease in luminous efficiency, and the saturation of luminance.

Japanese Patent Application Publication No. 2003-158294 discloses a technique for inhibiting the occurrence of the piezoelectric spontaneous polarization in the thickness direction of the active layer. According to the technique disclosed in the patent document, in the case where, for example, the top face of the active layer is parallel to the a-plane, the m-plane, or the plane {2-1-14}, the piezoelectric spontaneous polarization occurs in the direction perpendicular to the thickness direction of the active layer.

On the other hand, in recent years, to form GaN-based compound semiconductor layers having low crystal defect densities, various methods for laterally growing GaN-based compound semiconductor layers on sapphire substrates (hereinafter, referred to as "lateral epitaxial growth" or "epitaxial lateral overgrowth (ELOG)" techniques) have been studied. In general, when a plurality of seed layers that are apart from each other and that are composed of a GaN-based compound semiconductor are formed on a sapphire substrate, a GaN-based compound semiconductor layer grows laterally from the seed layers. In a region in which the GaN-based compound semiconductor layer grows laterally, dislocation grows only laterally as the GaN-based compound semiconductor layer grows and does not pass through the GaN-based compound semiconductor layer in the longitudinal direction (thickness direction), thus resulting in a GaN-based compound semiconductor layer having a low crystal defect density.

For example, Japanese Patent Application Publication No. 2002-100579 discloses one of the ELOG techniques. The technique disclosed in Japanese Patent Application Publication No. 2002-100579 includes a step of forming growth nuclei composed of a nitride semiconductor material in the form of a periodic striped pattern, islands, or grid on a substrate composed of a material different from the nitride semiconductor material; and a growing step of growing a nitride semiconductor layer from the growth nuclei in such a manner that the growth nuclei are bonded to each other at substantially intermediate positions between the nuclei to cover the entire surface of the substrate with the layer. In the growing step, after the partial growth of the nitride semiconductor layer, a protective film is formed on the growth nuclei, and then the nitride semiconductor layer is grown.

[Patent Document 1] Japanese Patent Application Publication No. 2003-158294
[Patent Document 2] Japanese Patent Application Publication No. 2002-100579

In the GaN compound semiconductor layer formed by the ELOG technique on the c-plane of a sapphire substrate, the top face corresponds to the c-plane, and the side face corresponds to the a-plane. That is, the top face of the GaN compound semiconductor layer is parallel to the {0001} plane of the GaN compound semiconductor crystal, and the side face of the GaN compound semiconductor layer is parallel to the following plane:

$$[\text{Expression 1}]$$

$$\{11\bar{2}0\} \text{ plane}$$

of the GaN compound semiconductor crystal. Hereinafter, the crystal plane is designated for convenience as the "{11-20} plane". Furthermore, in this specification, in a hexagonal system, for example, the following crystal planes:

[Expression 2]

$\{hk\bar{i}l\}$ plane

$\{h\bar{k}il\}$ plane

are designated for convenience as the {hk-il} plane and the {h-kil} plane, respectively. In this specification, the following directions:

[Expression 3]

$<hk\bar{i}l>$ direction

$<h\bar{k}il>$ direction

are designated for convenience as the <hk-il> direction and the <h-kil> direction.

In Japanese Patent Application Publication No. 2003-158294, the occurrence of the piezoelectric spontaneous polarization can be prevented in the thickness direction of the active layer. However, a p-contact 26 is directly connected to a p-type layer 24 disposed on the active layer; hence, it is disadvantageously difficult to reduce the driving voltage of the light-emitting diode.

Japanese Patent Application Publication No. 2002-100579 does not describe the problems and solutions when the GaN-based compound semiconductor layer exhibits piezoelectric spontaneous polarization.

Disclosure of Invention

It is a first object of the present invention to provide a GaN-based semiconductor light-emitting element that can inhibit the occurrence of piezoelectric spontaneous polarization in the thickness direction of an active layer and that can reduce the driving voltage of a light-emitting diode. In addition to the first object, it is a second object of the present invention to provide a method for producing a GaN-based semiconductor light-emitting element having a GaN-based compound semiconductor layer with a low crystal defect density.

To achieve the first object, a GaN-based semiconductor light-emitting element according to a first aspect of the present invention includes:

(A) a first GaN-based compound semiconductor layer having a first conductivity type and having a top face that is parallel to the a-plane;
(B) an active layer disposed on the first GaN-based compound semiconductor layer, the active layer having the top face that is parallel to the a-plane;
(C) a second GaN-based compound semiconductor layer disposed on the active layer, the second GaN-based compound semiconductor layer having a second conductivity type and having the top face that is parallel to the a-plane;
(D) a first electrode disposed on the first GaN-based compound semiconductor layer;
(E) a second electrode; and
(F) a contact layer disposed between the second GaN-based compound semiconductor layer and the second electrode, the contact layer being composed of a GaN-based compound semiconductor and having the top face that is parallel to the a-plane.

To achieve the first object, a GaN-based semiconductor light-emitting element according to a second aspect of the present invention includes:

(A) a first GaN-based compound semiconductor layer having a first conductivity type and having a top face that is parallel to the m-plane;
(B) an active layer disposed on the first GaN-based compound semiconductor layer, the active layer having the top face that is parallel to the m-plane;
(C) a second GaN-based compound semiconductor layer disposed on the active layer, the second GaN-based compound semiconductor layer having a second conductivity type and having the top face that is parallel to the m-plane;

(D) a first electrode disposed on the first GaN-based compound semiconductor layer;

(E) a second electrode; and

(F) a contact layer disposed between the second GaN-based compound semiconductor layer and the second electrode, the contact layer being composed of a GaN-based compound semiconductor and having the top face that is parallel to the m-plane.

To achieve the first object, a GaN-based semiconductor light-emitting element according to a third aspect of the present invention includes:

(A) a first GaN-based compound semiconductor layer having a first conductivity type and having a top face that is parallel to a nonpolar plane;

(B) an active layer disposed on the first GaN-based compound semiconductor layer, the active layer having the top face that is parallel to the nonpolar plane;

(C) a second GaN-based compound semiconductor layer disposed on the active layer, the second GaN-based compound semiconductor layer having a second conductivity type and having the top face that is parallel to the nonpolar plane;

(D) a first electrode disposed on the first GaN-based compound semiconductor layer;

(E) a second electrode; and

(F) a contact layer disposed between the second GaN-based compound semiconductor layer and the second electrode, the contact layer being composed of a GaN-based compound semiconductor and having the top face that is parallel to the nonpolar plane.

A compound semiconductor is composed of cations (e.g., Ga) and anions (e.g., N). Ga is considered to be positive trivalent. N is considered to be positive pentavalent or negative trivalent. A surface on which large or small amounts of Ga atoms and N atoms appear is referred to as a polar surface. For example, in the C+ plane, Ga atom planes and nitrogen atom planes appear alternately during growth. During this stage, directionality occurs vertically between cations with positive charges and anions with negative charges, which is referred to as "polarity". In contrast, for example, in the a-plane, symmetry occurs in the arrangement of Ga atoms and N atoms, and localization of one type of atom or directionality does not occur, which is referred to as "nonpolarity". Such a plane is referred to as a "nonpolar plane". In the nonpolar plane, as in the a-plane or the like, no symmetry occurs vertically between cation planes and anion planes.

More specifically, in the present specification, examples of the nonpolar plane include the a-plane that is the {11-20} plane, the m-plane that is the {1-100} plane, and the {11-2n} plane. The {11-2n} plane means a nonpolar plane at an angle of about 40° with respect to the c-plane. Since the top face of the active layer is parallel to the nonpolar plane, even when piezoelectric spontaneous polarization occurs in the active layer, piezoelectric spontaneous polarization does not occur in the thickness direction of the active layer but only occurs in the direction substantially perpendicular (for example, 90° or 90°±5°) to the thickness direction of the active layer.

To achieve the second object, a method for producing a GaN-based semiconductor light-emitting element according to the first aspect of the present invention includes the steps of:

(a) forming a plurality of seed layers on the r-plane of a sapphire substrate, the seed layers being composed of a GaN-based compound semiconductor and being apart from each other;

(b) forming first underlying GaN-based compound semiconductor layers by lateral epitaxial growth from seed layers, each of the first underlying GaN-based compound semiconductor layers having a top face that is parallel to the a-plane;

(c) forming mask layers each disposed on a portion of the top face of a corresponding one of the first underlying GaN-based compound semiconductor layers above the seed layers;

(d) forming second underlying GaN-based compound semiconductor layers each disposed on the top face of a corresponding one of the first underlying GaN-based compound semiconductor layers and each disposed on a corresponding one of the mask layers by lateral epitaxial growth from the top faces of the first underlying GaN-based compound semiconductor layers, each of the second underlying GaN-based compound semiconductor layers having the top face that is parallel to the a-plane;

(e) forming a first GaN-based compound semiconductor layer having a first conductivity type and having the top face that is parallel to the a-plane on the second underlying GaN-based compound semiconductor layers;

(f) forming an active layer with the top face that is parallel to the a-plane on the first GaN-based compound semiconductor layer;

(g) forming a second GaN-based compound semiconductor layer having a second conductivity type and having the top face that is parallel to the a-plane on the active layer; and

(h) forming a contact layer composed of a GaN-based compound semiconductor and having the top face that is parallel to the a-plane on the second GaN-based compound semiconductor layer.

To achieve the second object, a method for producing a GaN-based semiconductor light-emitting element according to the second aspect of the present invention includes the steps of:

(a) forming a plurality of seed layers on a $LiAlO_2$ substrate, the seed layers being composed of a GaN-based compound semiconductor and being apart from each other;

(b) forming first underlying GaN-based compound semiconductor layers by lateral epitaxial growth from seed layers, each of the first underlying GaN-based compound semiconductor layers having a top face that is parallel to the m-plane;

(c) forming mask layers each disposed on a portion of the top face of a corresponding one of the first underlying GaN-based compound semiconductor layers above the seed layers;

(d) forming second underlying GaN-based compound semiconductor layers each disposed on the top face of a corresponding one of the first underlying GaN-based compound semiconductor layers and each disposed on a corresponding one of the mask layers by lateral epitaxial growth from the top faces of the first underlying GaN-based compound semiconductor layers, each of the second underlying GaN-based compound semiconductor layers having the top face that is parallel to the m-plane;

(e) forming a first GaN-based compound semiconductor layer having a first conductivity type and having the top face that is parallel to the m-plane on the second underlying GaN-based compound semiconductor layers;

(f) forming an active layer with the top face that is parallel to the m-plane on the first GaN-based compound semiconductor layer;

(g) forming a second GaN-based compound semiconductor layer having a second conductivity type and having the top face that is parallel to the m-plane on the active layer; and

(h) forming a contact layer composed of a GaN-based compound semiconductor and having the top face that is parallel to the m-plane on the second GaN-based compound semiconductor layer.

In the method for producing a GaN-based semiconductor light-emitting element according to the first or second aspect (hereinafter, collectively referred to as a "method for producing a GaN-based semiconductor light-emitting element of the present invention"), preferably,

in the step (b), the first underlying GaN-based compound semiconductor layers are formed by lateral epitaxial growth from the seed layers, and then the lateral epitaxial growth is stopped before opposite side faces of the first underlying GaN-based compound semiconductor layers come into contact with each other, and

in the step (d), third underlying GaN-based compound semiconductor layers are formed by lateral epitaxial growth from opposite side faces of the first underlying GaN-based compound semiconductor layers while the second underlying GaN-based compound semiconductor layers are formed by lateral epitaxial growth. But the present invention is not limited thereto. For example, when the distance between opposite side faces of adjacent first underlying GaN-based compound semiconductor layers is expressed as L, and when the formation pitch of the plurality of seed layers is expressed as $P_S$, satisfying the expression $0.5 \leq L/PS \leq 0.99$ and preferably $0.6 \leq L/PS \leq 0.8$ is desirable from the viewpoint of the reduction of defects or from the viewpoint of the prevention of the detachment of the GaN-based compound semiconductor layer from the sapphire substrate or the $LiAlO_2$ substrate.

In the methods for producing the GaN-based semiconductor light-emitting elements including the above-described preferred embodiments, a second electrode is preferably formed on the contact layer after the formation of the contact layer. In this case, more preferably, the second electrode is located above a portion of a corresponding one of the second underlying GaN-based compound semiconductor layers disposed on the top faces of the first underlying GaN-based compound semiconductor layers. Still more preferably, in a plan view, the second electrode is within the portion of the corresponding one of the second underlying GaN-based compound semiconductor layers disposed on the top faces of the first underlying GaN-based compound semiconductor layers. In this case, further preferably, when the seed layers are each in the form of a strip having a width $W_S$ in a plan view, and when the mask layers are each in the form of a strip having a width $W_M$ in a plan view, the following expressions are satisfied:

$W_M/W_S > 1$ and preferably $1 < W_M/W_S < 2$; and

$W_{E2}/(P_S - W_M) < 1$ and preferably $W_{E2}/(P_S - W_M) < 0.5$

where $P_S$ represents the formation pitch of the plurality of seed layers; and $W_{E2}$ represents the width of the second electrode.

In the method for producing the GaN-based semiconductor light-emitting elements including the above-described preferred embodiments, preferably, the seed layers and the first underlying GaN-based compound semiconductor layers (and the third underlying GaN-based compound semiconductor layers) are detached from the r-plane of the sapphire substrate or the LiAlO$_2$ substrate after the formation of the second GaN-based compound semiconductor layer. More preferably, after the detachment of the seed layers and the first underlying GaN-based compound semiconductor layers (and the third underlying GaN-based compound semiconductor layers) from the r-plane of the sapphire substrate or the LiAlO$_2$ substrate, the seed layers, the first underlying GaN-based compound semiconductor layers, (the third underlying GaN-based compound semiconductor layers,) the second underlying GaN-based compound semiconductor layers, and the mask layers are removed so as to expose the first GaN-based compound semiconductor layer. Still more preferably, a first electrode is formed on the exposed first GaN-based compound semiconductor layer.

In the method for producing the GaN-based semiconductor light-emitting elements including the above-described preferred embodiments and structures, the lateral epitaxial growth of the first underlying GaN-based compound semiconductor layers is preferably performed by metal-organic chemical vapor deposition (MOCVD) with an organogallium source gas and a nitrogen source gas. In this case, the V/III ratio, i.e., the feed molar ratio of the nitrogen source gas to the organogallium source gas, is preferably $1 \times 10$ to $3 \times 10^3$ and more preferably $1 \times 10^2$ to $1 \times 10^3$. Alternatively, in the lateral epitaxial growth of the first underlying GaN-based compound semiconductor layers by metal-organic chemical vapor deposition, the number of moles of the organogallium source gas fed per square centimeter of the sapphire substrate or LiAlO$_2$ substrate per minute is preferably set at $0.5 \times 10^{-6}$ mol·cm$^{-2}$·min$^{-1}$ to $5 \times 10^{-6}$ mol·cm$^{-2}$ ·min$^{-1}$ and more preferably $0.5 \times 10^{-6}$ mol·cm$^{-2}$·min$^{-1}$ to $2 \times 10^{-6}$ mol·cm$^{-2}$·min$^{-1}$. Alternatively, in the lateral epitaxial growth of the first underlying GaN-based compound semiconductor layers by metal-organic chemical vapor deposition, the pressure of the nitrogen source gas is preferably set at $1 \times 10^3$ Pa to $3 \times 10^4$ Pa and more preferably $1 \times 10^3$ Pa to $1 \times 10^4$ Pa. By setting the V/III ratio, the number of moles of the organogallium source gas fed, and the pressure of the nitrogen source gas in the range described above, the lateral epitaxial growth of the first underlying GaN-based compound semiconductor layers can be performed reliably and stably. The phrase "pressure of the nitrogen source gas" refers to a pressure in a region for forming the GaN-based compound semiconductor layer in a film-forming chamber used for forming the GaN-based compound semiconductor layer of the MOCVD apparatus. Hereinafter, the phrase "pressure of the nitrogen source gas" is also used in the same meaning.

In the method for producing the GaN-based semiconductor light-emitting elements including the above-described preferred embodiments and structures, the lateral epitaxial growth of the second underlying GaN-based compound semiconductor layers (and the third underlying GaN-based compound semiconductor layers) is preferably performed by metal-organic chemical vapor deposition (MOCVD) with an organogallium source gas and a nitrogen source gas. In this case, the V/III ratio, i.e., the feed molar ratio of the nitrogen source gas to the organogallium source gas, is preferably $1 \times 10$ to $3 \times 10^3$ and more preferably $1 \times 10^2$ to $1 \times 10^3$. Alternatively, in the lateral epitaxial growth of the second underlying GaN-based compound semiconductor layers (and the third underlying GaN-based compound semiconductor layers) by metal-organic chemical vapor deposition, the number of moles of the organogallium source gas fed per square centimeter of the sapphire substrate or LiAlO$_2$ substrate per minute is preferably set at $0.5 \times 10^{-6}$ mol·cm$^{-2}$·min$^{-1}$ to $5 \times 10^{-6}$ mol·cm$^{-2}$·min$^{-1}$ and more preferably $0.5 \times 10^{-6}$ mol·cm$^{-2}$·min$^{-1}$ to $2 \times 10^{-6}$ mol·cm$^{-2}$·min$^{-1}$. Alternatively, in the lateral epitaxial growth of the second underlying GaN-based compound semiconductor layers (and the third underlying GaN-based compound semiconductor layers) by metal-organic chemical vapor deposition, the pressure of the nitrogen source gas is preferably set at $1 \times 10^3$ Pa to $3 \times 10^4$ Pa and more preferably $1 \times 10^3$ Pa to $1 \times 10^4$ Pa. By setting the V/III ratio, the number of moles of the organogallium source gas fed, and the pressure of the nitrogen source gas in the range described above, the lateral epitaxial growth of the second underlying GaN-based compound semiconductor layers and the third underlying GaN-based compound semiconductor layers can be performed reliably and stably.

In the methods for producing the GaN-based semiconductor light-emitting elements including the above-described preferred embodiments and structures, preferably, the seed layers and the mask layers are each in the form of a strip in a plan view. The projection of each seed layer is preferably parallel to the projection of the corresponding mask layer. Furthermore, in a plan view, each of the seed layers is preferably located within a corresponding one of the mask layers. In addition, preferably, the relationship $1 < W_M/W_S$ is satisfied, and more preferably, the relationship $1 < _M/W_S \le 2$ is satisfied, where $W_S$ represents the width of each seed layer; and $W_M$ represents the width of each mask layer. Furthermore, preferably, the relationship $0.01 < W_S/P_S < 0.5$ is satisfied, and more preferably, the relationship $0.1 \le W_S/P_S \le 0.3$ is satisfied, where $P_S$ represents the formation pitch of the plurality of seed layers. When the relationship $1 < W_M/W_S$ is satisfied, the crystal defect density in the resulting second underlying GaN-based compound semiconductor layers can be reliably reduced. When the top face of the first GaN-based compound semiconductor layer having the first conductivity type is parallel to the a-plane, the direction in which the strip seed layers extend is preferably set in the <1-100> direction.

In the GaN-based semiconductor light-emitting elements according to the first to third aspects of the present invention (hereinafter, in some cases, collectively referred to as "GaN-based semiconductor light-emitting elements of the present invention") and in the methods for producing the GaN-based semiconductor light-emitting elements including the above-described preferred structures (hereinafter, in some cases, collectively referred to as "the present invention"), the GaN-based compound semiconductor constituting the contact layer is preferably $In_XGa_{(1-X)}N$ (may contain Al). For example, the X value preferably satisfies the relationship $0.01 \leq X \leq 0.3$. The contact layer may contain a dopant or not. In the former case, when the first conductivity type is an n-type, and when the second conductivity type is a p-type, the Mg atomic concentration in the contact layer is preferably $1 \times 10^{19}/cm^3$ to $1 \times 10^{21}/cm^3$.

In the present invention including the above-described preferred embodiments and structures, when the first conductivity type is an n-type, and when the second conductivity type is a p-type, the Mg atomic concentration in the second GaN-based compound semiconductor layer is preferably $1 \times 10^{19}/cm^3$ to $1 \times 10^{21}/cm^3$ and more preferably $5 \times 10^{19}/cm^3$ to $2 \times 10^{20}/cm^3$. From the viewpoint of the improvement of luminous efficiency, the active layer preferably has a single-quantum-well structure (QW structure) of $In_YGaN_{(1-Y)}$ sublayer/GaN sublayer or a multiple-quantum-well structure (MQW structure) of $In_YGaN_{(1-Y)}$ sublayer/GaN sublayer, the number of wells being two to five. When the luminescence wavelength is in the range of 440 nm to 470 nm, the Y value preferably satisfies $0.13 \leq Y \leq 0.20$. When the luminescence wavelength is in the range of 500 nm to 530 nm, the Y value preferably satisfies $0.20 \leq Y \leq 0.30$.

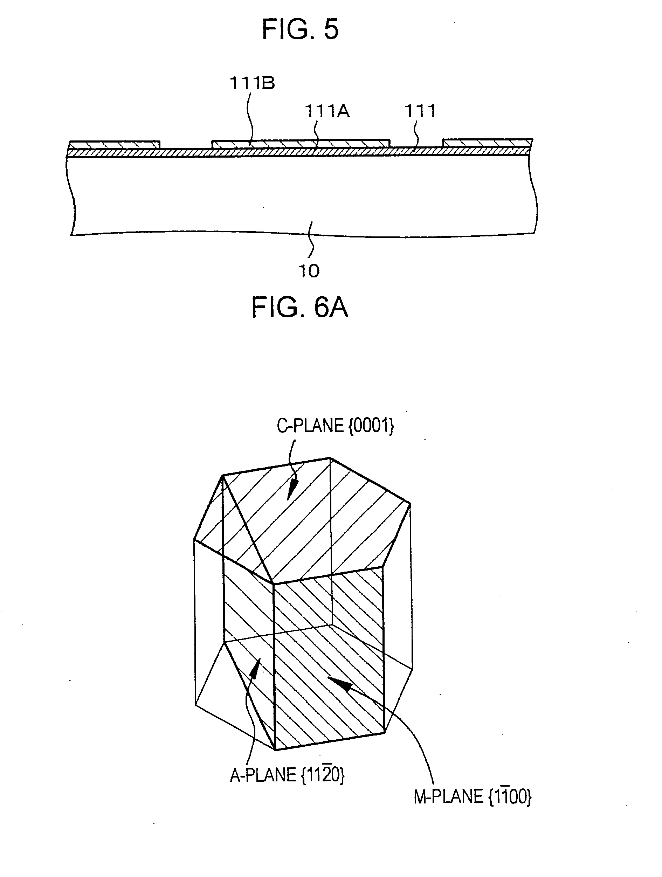

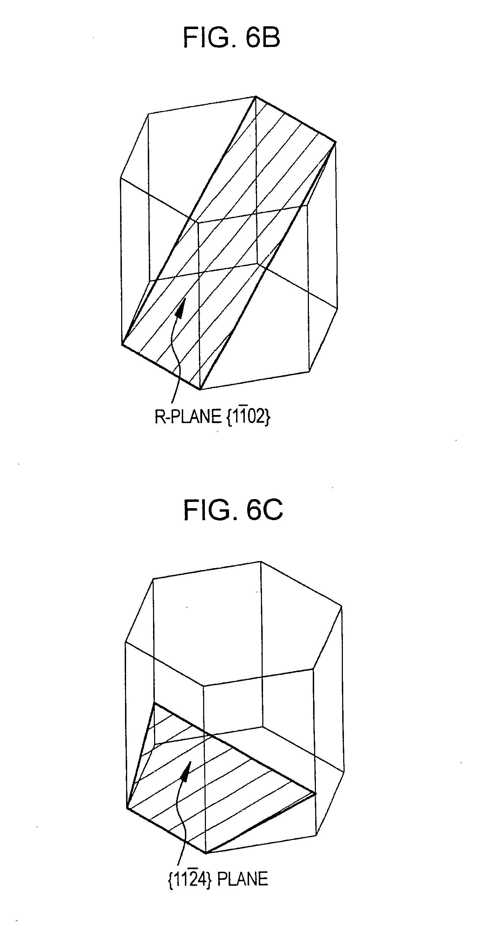

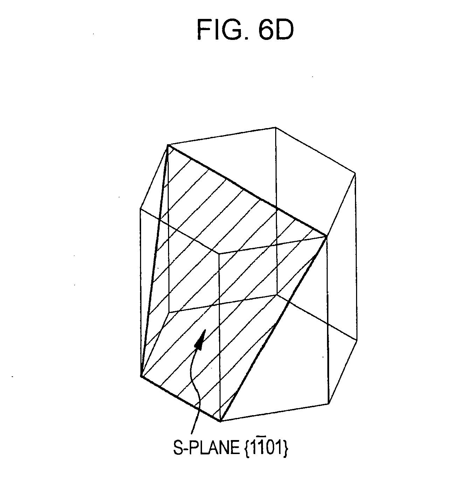

The term "lateral epitaxial growth" means epitaxial lateral overgrowh (ELOG). Hereinafter, for convenience sake, when the top face is parallel to the a-plane, the term "a-plane growth" is used. When the top face is parallel to the m-plane, the term "m-plane growth" is used. When the top face is parallel to the c-plane, the term "c-plane growth" is used. Figs. 6A to 6D show the a-plane, the m-plane, the {11-2n} plane, the c-plane, the r-plane, and the s-plane of the hexagonal system. In this specification, top faces of the GaN-based compound semiconductor layers parallel to the r-plane, the a-plane, the m-plane, a nonpolar plane, and the like of the sapphire substrate include planes at an off angle $\pm$ within 5 (degree).

In the present invention including the above-described preferred embodiments and structures, examples of the first GaN-based compound semiconductor layer, the active layer, the second GaN-based compound semiconductor layer, the first underlying GaN-based compound semiconductor layers, the second underlying GaN-based compound semiconductor layers, and the third underlying GaN-based compound semiconductor layers include GaN layers, AlGaN layers, InGaN layers, AlInGaN layers, and GaN-based compound semiconductor layers containing boron (B) atoms or thallium (Tl) atoms.

The seed layers each composed of the GaN-based compound semiconductor can be obtained by forming a GaN-based compound semiconductor layer (for example, a GaN layer with the top face parallel to the a-plane or a GaN layer with the top face parallel to the m-plane) on the r-plane of a sapphire substrate or a $LiAlO_2$ substrate and then patterning the GaN-based compound semiconductor layer by lithography and etching. Alternatively, the seed layers each composed of the GaN-based compound semiconductor can be obtained by forming a GaN-based compound semiconductor layer (for example, a GaN layer with the top face parallel to the a-plane or a GaN layer with the top face parallel to the m-plane) on the r-plane of a sapphire substrate or a $LiAlO_2$ substrate, forming a non-growing layer (i.e., a layer on which crystal growth of a GaN compound semiconductor layer does not occur) thereon, and then patterning the non-growing layer by lithography and etching to expose the GaN-based compound semiconductor layer. The material constituting the non-growing layer may be appropriately selected from materials constituting the mask layers described below. Examples of the method for forming the GaN-based compound semiconductor layers constituting the seed layers include MOCVD, molecular beam epitaxy (MBE), and hydride vapor deposition in which a halogen contributes to transportation or reaction.

In the method for producing the GaN-based semiconductor light-emitting element according to the present invention, no GaN-based compound semiconductor layer grows on the mask layers. The growth of the second underlying GaN-based compound semiconductor layers start on the first underlying GaN-based compound semiconductor layers, and the second underlying GaN-based compound semiconductor layers extend over the mask layers. Specific examples of mask layers include silicon oxide layers ($SiO_x$ layers), silicon nitride layers ($SiN_y$ layers), $Ta_2O_5$ layers, $ZrO_2$ layers, AlN layers, $Al_2O_3$ layers, stacked structures of these layers (for example, a structure including a silicon oxide layer and a silicon nitride layer stacked from the bottom), and refractory metal material layers, such as Ni layers and tungsten layers. The mask layers can be formed by chemical vapor deposition (CVD) or physical vapor deposition (PVD), such as vacuum evaporation or sputtering.

In the methods for producing the GaN-based semiconductor light-emitting elements including various preferred embodiments and structures, examples of the method for forming the first GaN-based compound semiconductor layer, the active layer, the second GaN-based compound semiconductor layer, and the contact layer include MOCVD, MBE, and hydride vapor deposition in which a halogen contributes to transportation or reaction.

Examples of the organogallium source gas include a trimethylgallium (TMG) gas and a triethylgallium (TEG) gas. Examples of the nitrogen source gas include an ammonia gas and hydrazine gas. In general, examples of a combination of the first conductivity type and the second conductivity type include a combination of the n-type and the p-type and a combination of the p-type and the n-type. For the formation of an n-type GaN-based compound semiconductor layer, for example, silicon (Si) may be added as an n-type dopant. For the formation of a p-type GaN-based compound semiconductor layer, for example, magnesium (Mg) may be added as a p-type dopant. Furthermore, when the GaN-based compound semiconductor layer contains aluminum (Al) or indium (In) as a constituent atom, a trimethylaluminum (TMA) gas may be used as an Al source, and a trimethylindium (TMI) gas may be used as an In source. Furthermore, a monosilane gas ($SiH_4$ gas) may be used as a Si source, and a cyclopentadienylmagnesium gas may be used as a Mg source. In general, in addition to Si, examples of the n-type dopant include Ge, Se, Sn, C, and Ti. In addition to Mg, examples of the p-type dopant include Zn, Cd, Be, Ca, Ba, and O.

In the present invention including various preferred embodiments and structures, when the second conductivity type is the p-type, the second electrode preferably has a single-layer structure or a multilayer structure containing at least one metal selected from the group consisting of palladium (Pd), platinum (Pt), nickel (Ni), gold (Au), and silver (Ag). In contrast, when the first conductivity type is the n-type, the first electrode preferably has a single-layer structure or a multilayer structure containing at least one metal selected from the group consisting of gold (Au), Al (aluminum), Ti (titanium), tungsten (W), Cu (copper), Zn (zinc), tin (Sn), and indium (In). Examples thereof include Ti/Au, Ti/Al, and Ti/Pt/Au. The first and second electrodes may be formed by PVD, such as vacuum evaporation or sputtering.

In the methods for producing the GaN-based semiconductor light-emitting elements including various preferred embodiments and structures, examples of a method for detaching the seed layers, the first underlying GaN-based compound semiconductor layers (and the third underlying GaN-based compound semiconductor layers) from the r-plane of the sapphire substrate or the $LiAlO_2$ substrate include a method for irradiating interfaces between either the sapphire substrate or the $LiAlO_2$ substrate and the seed layers and the first underlying GaN-based compound semiconductor layers (and the third underlying GaN-based compound semiconductor layers) with laser light (for example, KrF excimer-laser light having a wavelength of 248 nm) through the sapphire substrate or the $LiAlO_2$ substrate. In addition, examples of a method for removing the seed layers, the first underlying GaN-based compound semiconductor layers, (third underlying GaN-based compound semiconductor layers), the second underlying GaN-based compound semiconductor layers, and the mask layers include methods in which the seed layers, the first underlying GaN-based compound semiconductor layers, (third underlying GaN-based compound semiconductor layers), the second underlying GaN-based compound semiconductor layers, and the mask layers are subjecting etching, polishing, or a combination of etching and polishing.

Examples of the GaN-based semiconductor light-emitting element of the present invention or a light-emitting element obtained by the production method include light-emitting diodes (LEDs) and semiconductor lasers (LDs). The type and structure of the GaN compound semiconductor are not particularly limited, and the type and structure of the GaN compound semiconductor layer are also not particularly limited, as long as the stacked structure including the GaN-based compound semiconductor layers is a light-emitting diode structure or a laser structure.

In the present invention, the top face of each of the GaN-based compound semiconductor layers constituting the GaN-based semiconductor light-emitting element is parallel to the a-plane, the m-plane, or a nonpolar plane. Thus, even when piezoelectric spontaneous polarization occurs in the active layer, piezoelectric spontaneous polarization does not occur in the thickness direction of the active layer but occurs in the direction substantially perpendicular to the thickness direction of the active layer. Therefore, it is possible to prevent the occurrence of phenomena, such as a shift in the wavelength of light emitted from the light-emitting diode, an increase in operating voltage, a reduction in luminous efficiency, and the saturation of luminance. Furthermore, since the contact layer is disposed between the second electrode and the second GaN-based compound semiconductor layer on the active layer, the driving voltage can be surely reduced.

In general, for example, the a-plane growth or m-plane growth of a GaN-based compound semiconductor layer can be performed on the r-plane of a sapphire substrate or a $LiAlO_2$ substrate. However, the resulting GaN-based compound semiconductor layer has an extremely large number of crystal defects, and the surface thereof has irregularities. Therefore, for example, when an active layer including a GaN-based compound semiconductor layer is formed directly on the GaN-based compound semiconductor layer, the irregularities increase, thereby possibly leading to extremely weak luminescence of the resulting GaN-based semiconductor light-emitting element.

In the method for producing the GaN-based semiconductor light-emitting element, the first underlying GaN-based compound semiconductor layers are formed by lateral epitaxial growth from the seed layers; hence, basically, the first underlying GaN-based compound semiconductor layers each having an extremely low crystal defect density can be obtained. However, the crystal defect density of a portion of each of the first underlying GaN-based compound semiconductor layers grown on the seed layers is high. Thus, in the method for producing the GaN-based semiconductor light-emitting element, the second underlying GaN-based compound semiconductor layers are formed on top faces of the first underlying GaN-based compound semiconductor layers while top faces of the high-crystal-defect-density portions of the first underlying GaN-based compound semiconductor layers grown on the seed layers are covered with the mask layers. As a result, the crystal defect density in the resulting second underlying GaN-based compound semiconductor layers is extremely low as a whole.

Furthermore, the top face of each of the resulting second underlying GaN-based compound semiconductor layers is parallel to the a-plane, the m-plane, or the nonpolar plane. The side face thereof corresponds to the c-plane or the like. Accordingly, in each of the first GaN-based compound semiconductor layer, the active layer composed of a GaN-based compound semiconductor, the second GaN-based compound semiconductor layer, and the contact layer formed in that order on the second underlying GaN-based compound semiconductor layers, the top face thereof is parallel to the a-plane, the m-plane, or the nonpolar plane. The side face (for example, c-plane) is perpendicular to the interfaces. Thus, even when piezoelectric spontaneous polarization occurs in the active layer, piezoelectric spontaneous polarization does not occur in the thickness direction of the active layer but occurs in the direction substantially perpendicular to the thickness direction of the active layer. Therefore, it is possible to prevent the occurrence of phenomena, such as a shift in the wavelength of light emitted from the light-emitting diode, an increase in operating voltage, a reduction in luminous efficiency, and the saturation of luminance.

In a GaN compound semiconductor crystal, the coefficient of thermal expansion in the c-axis direction is extremely smaller than the coefficient of thermal expansion of a sapphire substrate. Consequently, a GaN-based compound semiconductor layer may be detached from a sapphire substrate due to a large change in temperature. Thus, in the step (b), the first underlying GaN-based compound semiconductor layers are formed by lateral epitaxial growth from seed layers. The lateral epitaxial growth is stopped before opposite side faces of adjacent first underlying GaN-based compound semiconductor layers come into contact with each other. Therefore, for example, the GaN-based compound semiconductor layer can be reliably prevented from being detached from the sapphire substrate due to the difference in the coefficient of thermal expansion when the temperature of the sapphire substrate or the like is reduced in order to form the mask layers.

Brief Description of the Drawings

Fig. 1 is a schematic partial cross-sectional view of a GaN-based semiconductor light-emitting element according to a first embodiment or a fourth embodiment.
Fig. 2A is a schematic partial end view of a substrate, such as a sapphire substrate, for illustrating a method for producing the GaN-based semiconductor light-emitting element according to the first embodiment or the fourth embodiment.
Fig. 2B is a schematic partial end view of a substrate, such as a sapphire substrate, for illustrating a method for producing the GaN-based semiconductor light-emitting element according to the first embodiment or the fourth embodiment.
Fig. 2C is a schematic partial end view of a substrate, such as a sapphire substrate, for illustrating a method for producing the GaN-based semiconductor light-emitting element according to the first embodiment or the fourth embodiment.
Fig. 2D is a schematic partial end view of a substrate, such as a sapphire substrate, for illustrating a method for producing the GaN-based semiconductor light-emitting element according to the first embodiment or the fourth embodiment.
Fig. 3A is a schematic partial end view of a substrate, such as a sapphire substrate, for illustrating a method for producing the GaN-based semiconductor light-emitting element according to a second embodiment or a fifth embodiment.
Fig. 3B is a schematic partial end view of a substrate, such as a sapphire substrate, for illustrating a method for producing the GaN-based semiconductor light-emitting element according to the second embodiment or the fifth embodiment.
Fig. 3C is a schematic partial end view of a substrate, such as a sapphire substrate, for illustrating a method for producing the GaN-based semiconductor light-emitting element according to the second embodiment or the fifth embodiment.
Fig. 3D is a schematic partial end view of a substrate, such as a sapphire substrate, for illustrating a method for producing the GaN-based semiconductor light-emitting element according to the second embodiment or the fifth embodiment.
Fig. 4 is a graph showing the relationship between the number of quantum wells of quantum wells constituting an active layer and the driving voltage of the GaN-based semiconductor light-emitting element according to the second embodiment.
Fig. 5 is a schematic partial end view of a substrate such as a sapphire substrate for illustrating an another method for forming a seed layer in each of the methods for producing the GaN-based semiconductor light-emitting elements according to the first embodiment to a sixth embodiment.
Fig. 6A illustrates planes of a crystal that belongs to the hexagonal system.
Fig. 6B illustrates a plane of a crystal that belongs to the hexagonal system.
Fig. 6C illustrates a plane of a crystal that belongs to the hexagonal system.
Fig. 6D illustrates a plane of a crystal that belongs to the hexagonal system.

Best Mode for Carrying Out the Invention

The present invention will be described on the basis of embodiments with reference to the drawings.

FIRST EMBODIMENT

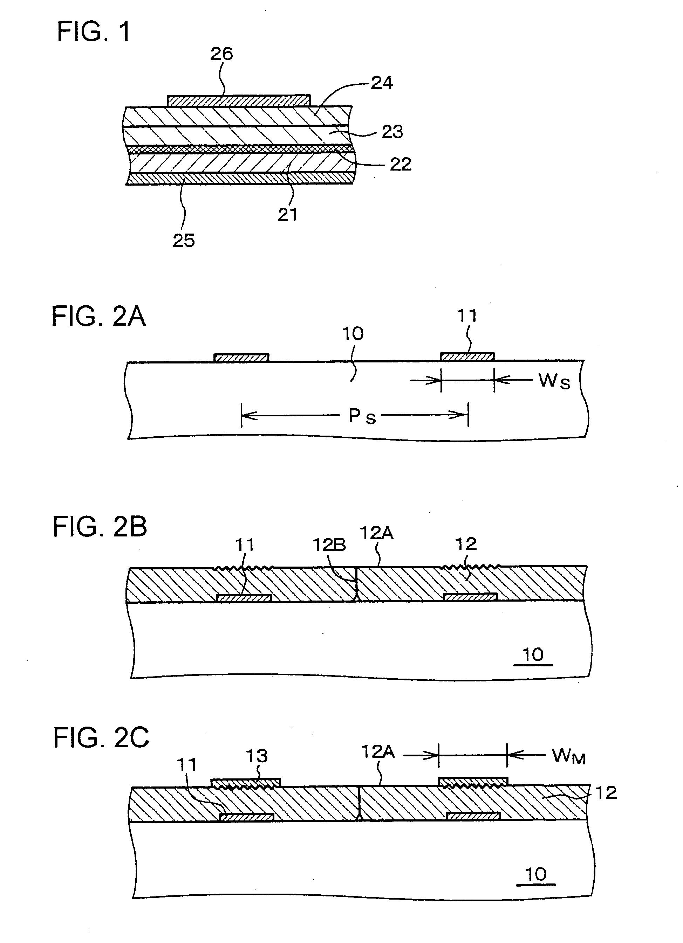

A first embodiment relates to a GaN-based semiconductor light-emitting element according to a first aspect and a third aspect of the present invention. Furthermore, the first embodiment relates to a method for producing the GaN-based semiconductor light-emitting element according to the first aspect of the present invention. Fig. 1 is a schematic cross-sectional view of the GaN-based semiconductor light-emitting element, more specifically, a light-emitting diode (LED) according to the first embodiment.

The GaN-based semiconductor light-emitting element according to the first embodiment has a structure in which a first GaN-based compound semiconductor layer 21, an active layer 22, a second GaN-based compound semiconductor layer 23, and a contact layer 24 are stacked. The top face of the first GaN-based compound semiconductor layer 21 is parallel to the a-plane or a nonpolar plane and has a first conductivity type (specifically, n-type). The active layer 22 is disposed on the first GaN-based compound semiconductor layer 21 and has the top face parallel to the a-plane or the nonpolar plane. In the first embodiment, the active layer 22 has a multiple-quantum-well structure: $In_YGaN_{(1-Y)}$ sublayer/GaN sublayer (Y = 0.20) (number of wells = 5). The second GaN-based compound semiconductor layer 23 is disposed on the active layer 22, has the top face parallel to the a-plane or the nonpolar plane, and has a second conductivity type (specifically, p-type). More specifically, the Mg atomic concentration of the second GaN-based compound semiconductor layer 23 is $8 \times 10^{19}/cm^3$.

The contact layer 24 has a thickness of 10 nm, is disposed on the second GaN-based compound semiconductor layer 23, is composed of a GaN-based compound semiconductor (specifically, $In_XGa_{(1-X)}N$, X = 0.15), and has the top face parallel to the a-plane or the nonpolar plane. The Mg atomic concentration of the contact layer 24 is $5 \times 10^{19}/cm^3$.

In the first embodiment, a first electrode 25 is disposed on the first GaN-based compound semiconductor layer 21, and a second electrode 26 is disposed on the contact layer 24.

A method for producing the GaN-based semiconductor light-emitting element according to the first embodiment will be described below with reference to Figs. 2A to 2D that are each a schematic partial end view of a substrate such as a sapphire substrate. In each embodiment, description is made on the basis of a gas flow rate (unit: SLM). The number of moles of a gas fed (unit: $10^{-6}$ mol·cm$^{-2}$·min$^{-1}$) can be obtained by multiplying the gas flow rate by a coefficient. A gas flow rate of 1 SLM is equal to $4.5 \times 10^{-2}$ mol·min$^{-1}$. The coefficient can be obtained by dividing this value by an equivalent area S. In the first embodiment, the equivalent area S is 60 cm$^2$.

[Step-100]

A plurality of seed layers 11 that are composed of a GaN-based compound semiconductor and that are apart from each other are formed on the r-plane of a sapphire substrate 10 (indicated by a substrate 10 in the figure) (see Fig. 2A). The r-plane of the sapphire substrate 10 corresponds to the {1-102} plane. Specifically, the sapphire substrate 10 is placed in an MOCVD apparatus. A flat GaN-based compound semiconductor layer having a thickness of about 2 $\mu$m is formed on the r-plane of the sapphire substrate 10 by MOCVD with a trimethylgallium (TMG) gas as an organogallium source gas and an ammonia gas as a nitrogen source gas under conditions such that a mirror surface is formed by appropriately selecting the V/III ratio, i.e., the feed molar ratio of the nitrogen source gas to the organogallium source gas, so as to minimize the occurrence of pits and the like. Specifically, a GaN layer with the top face parallel to the a-plane is formed on the r-plane of the sapphire substrate 10. The resulting GaN-based compound semiconductor layer has high-density defects, such as stacking faults. The sapphire substrate 10 is removed from the MOCVD apparatus. The GaN-based compound semiconductor layer is patterned by lithography and RIE to form strips in a plan view, thereby forming the plurality of seed layers 11 that are apart from each other. In this case, the seed layers 11 each extend in the <1-100> direction, and

$$W_S = 10 \ \mu m$$

$$P_S = 40 \ \mu m$$

where $W_S$ represents the width of the single strip of the seed layers 11; and $P_S$ represents the pitch of the plurality of seed layers.

[Step-110]

First underlying GaN-based compound semiconductor layers 12 each having the top face 12A parallel to the a-plane and having a side face 12B parallel to the c-plane are formed by lateral epitaxial growth from the seed layers 11 (see Fig. 2B). In the first embodiment, the lateral epitaxial growth of the first underlying GaN-based compound semiconductor layers 12 is stopped when opposite side faces 12B of the first underlying GaN-based compound semiconductor layers 12 come into contact with each other. Specifically, the sapphire substrate 10 is placed in the MOCVD apparatus again. The first underlying GaN-based compound semiconductor layers 12 each having the top face 12A parallel to the a-plane and having the side face 12B parallel to the c-plane are grown from the seed layers 11 by lateral epitaxial growth using MOCVD with a trimethylgallium (TMG) gas as an organogallium source gas and an ammonia gas as a nitrogen source gas. Table 1 shows exemplary film-forming conditions.
[Table 1]

| V/III ratio: | about 500 |
|---|---|
| Flow rate of organogallium source gas: | $4.5 \times 10^{-6}$ mol·cm$^{-2}$·min$^{-1}$ |
| Flow rate of nitrogen source gas: | 1 SLM |
| Net growth rate: | 12 $\mu$m/hr |
| Pressure of nitrogen source gas: | $1 \times 10^4$ Pa |

When the pressure of the nitrogen source gas was set at $9 \times 10^4$ Pa, the top face of the first underlying GaN-based compound semiconductor layers 12 was the s-plane, i.e., {1-101} plane.
The sapphire substrate 10 is removed from the MOCVD apparatus. Mask layers 13 are formed on portions of the top faces 12A of the first underlying GaN-based compound semiconductor layers 12 above the seed layers 11 (see Fig. 2C). Each mask layer 13 has a structure in which a silicon oxide sublayer and a silicon nitride sublayer are stacked in that order from the bottom. The mask layers 13 can be formed by plasma CVD, lithography, or wet etching. Each mask layer 13 is in the form of a strip in a plan view and has a width $W_M$ of 16 $\mu$m. That is, each of the seed layers 11 is located within a corresponding one of the mask layers 13 in a plan view, and $W_M/W_S = 1.6$.
The projection of each seed layer 11 is parallel to the projection of a corresponding one of the mask layers 13. The center line of each mask layer 13 may be located directly above the center line of the corresponding seed layer 11. Alternatively, the center line of each mask layer 13 may be located at a position other than the position directly above the center line of the corresponding seed layer 11. That is, in the portion of each first underlying GaN-based compound semiconductor layer 12 above the corresponding seed layer 11, a larger number of crystal defects may occur in the <0001> direction or in the <000-1> direction of each first underlying GaN-based compound semiconductor layer 12 compared with the number of crystal defects that occur above the center line of the corresponding seed layer 11, in response to growth conditions of the first underlying GaN-based compound semiconductor layers 12. In this case, in the formation of the mask layers 13, positions of the mask layers 13 are adjusted in such a manner that the center line of each mask layer 13 is located at a position other than the position directly above the center line of the corresponding seed layer 11 and in such a manner that the crystal defects in the portions of the first underlying GaN-based compound semiconductor layers 12 above the seed layers 11 are maximally covered with the mask layers 13.
In the case of the crystal defects in the portions of the first underlying GaN-based compound semiconductor layers 12 above the seed layers 11 are difficult to identify, for example, by further forming the first underlying GaN-based compound semiconductor layers 12 each having a thickness of about 1 $\mu$m under film-forming conditions exemplified in Table 2, pits are likely to occur in the crystal defect portions in the first underlying GaN-based compound semiconductor layers 12. Thus, the crystal defects can be easily identified.
[Table 2]

| V/III ratio: | about 8,000 |
|---|---|
| Flow rate of nitrogen source gas: | 6 SLM |
| Lateral growth rate: | 4 $\mu$m/hr |
| Pressure of nitrogen source gas: | $9 \times 10^4$ Pa |

[Step-130]

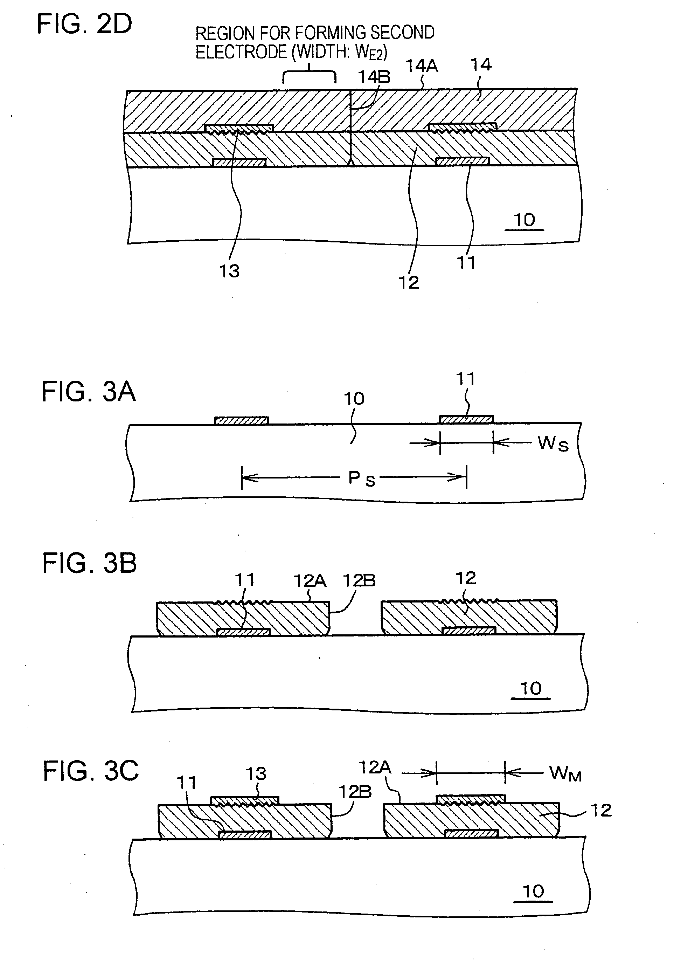

Second underlying GaN-based compound semiconductor layers 14 each having the top face 14A parallel to the a-plane and each having a side face 14B parallel to the c-plane are formed on the top faces 12A of the first underlying GaN-based compound semiconductor layers 12 and the mask layers 13 by lateral epitaxial growth from the top faces 12A of the first underlying GaN-based compound semiconductor layers 12 (see Fig. 2D). Specifically, the sapphire substrate 10 is placed in the MOCVD apparatus again. The second underlying GaN-based compound semiconductor layers 14 each having the top face 14A parallel to the a-plane and each having a side face 14B parallel to the c-plane are laterally grown by MOCVD with a trimethylgallium (TMG) gas as an organogallium source gas and an ammonia gas as a nitrogen source gas from the top faces 12A of the first underlying GaN-based compound semiconductor layers 12. The same film-forming conditions as in Table 1 may be applied.

Thereby, the GaN-based compound semiconductor layers can be formed.

[Step-140]

The first GaN-based compound semiconductor layer 21 (specifically, for example, a Si-doped GaN layer having a thickness of about 1 $\mu$m), the active layer 22 composed of a GaN-based compound semiconductor (specifically, for example, a multiple-quantum-well structure [MQW structure] in which $In_Y GaN_{(1-Y)}$ sublayer having a thickness of 2 to 3 nm and a GaN sublayer having a thickness of 7 to 20 nm are stacked), the second GaN-based compound semiconductor layer 23 (specifically, for example, a Mg-doped AlGaN sublayer having a thickness of 5 to 20 nm and a Mg-doped GaN sublayer having a thickness of 100 nm), and the contact layer 24 (specifically, for example, a Mg-doped $In_X Ga_{(1-X)}N$ layer having a thickness of 10 nm) are formed in that order by a known MOCVD on the second underlying GaN-based compound semiconductor layers 14 in the same MOCVD apparatus without a reduction in the temperature of the sapphire substrate 10 to a low temperature. The first GaN-based compound semiconductor layer is preferably formed under growth conditions shown in Table 3 so as to have a smaller number of crystal defects.

[Table 3]

| | |
|---|---|
| V/III ratio: | 1,000 or more |
| Pressure of nitrogen source gas: | $5 \times 10^4$ Pa or more |

[Step-150]

The second electrode 26 is formed on the contact layer 24. The second electrode 26 has a stacked structure of Ni layer/Ag layer/Au layer. The second electrode 26 can be formed by vacuum evaporation. The second electrode 26 is formed above a portion of the second underlying GaN-based compound semiconductor layer 14 formed on the top face 12A of a corresponding one of the first underlying GaN-based compound semiconductor layers 12. In a plan view, the second electrode 26 is located within the portion of the second underlying GaN-based compound semiconductor layer 14 formed on the top face 12A of the corresponding first underlying GaN-based compound semiconductor layer 12. The second electrode 26 may be in the form of a strip, a circle, an ellipse, or the like in a plan view. The width $W_{E2}$ (the width in the same direction as in the width of each mask layer 13) of the second electrode 26 is 14 $\mu$m. Preferably, the second electrode 26 is not formed on a portion of the second underlying GaN-based compound semiconductor layer 14 above a corresponding one of the mask layers 13. More preferably, the second electrode 26 is formed so as not to extend across the junction between the adjacent second underlying GaN-based compound semiconductor layers 14.

[Step-160]

A support layer is formed on the entire surface. Alternatively, a support is bonded to the entire surface. Then, the seed layers 11 and the first underlying GaN-based compound semiconductor layers 12 are detached from the r-plane of the sapphire substrate 10. Specifically, interfaces between the sapphire substrate 10 and the seed layers 11 and between the sapphire substrate 10 and the first underlying GaN-based compound semiconductor layers 12 may be irradiated with laser light, such as KrF excimer-laser light having a wavelength of 248 nm, through the sapphire substrate 10. Then, the seed layers 11, the first underlying GaN-based compound semiconductor layers 12, the mask layers 13, and the second underlying GaN-based compound semiconductor layers 14 are removed by a combination of etching and polishing to expose the first GaN-based compound semiconductor layer 21. The first electrode 25 is formed on the exposed first GaN-based compound semiconductor layer 21. The first electrode 25 has a stacked structure of Ti layer/Au layer. Furthermore, a transparent electrode (not shown) composed of ITO and connected to the first electrode 25 is formed.

[Step-170]

The stacked structure including the first GaN-based compound semiconductor layer 21, the active layer 22 composed of the GaN-based compound semiconductor, the second GaN-based compound semiconductor layer 23, and the contact layer 24 is cleaved and cut to form an LED chip. Mounting is performed in such a manner that the transparent electrode is located at the top. Wiring and resin molding are performed. Thereby, a GaN semiconductor light-emitting element including a shell-shaped LED device can be obtained.

The luminescence wavelength of the LED device can be controlled in the range of 450 nm to 530 nm by adjusting the In content (Y value) of the $In_YGa_{(1-Y)}N$ sublayer constituting the active layer 22.

Alternatively, in the case where the first GaN-based compound semiconductor layer 21 is an AlGaN layer, the active layer 22 is a GaN layer, an InGaN layer, or an AlInGaN layer, and the second GaN-based compound semiconductor layer 23 is an AlGaN layer, the luminescence wavelength of the LED device can be controlled in the range of 360 nm to 400 nm.

SECOND EMBODIMENT

A second embodiment is the modification of the first embodiment.

In the first embodiment, lateral epitaxial growth of the first underlying GaN-based compound semiconductor layers 12 is stopped when opposite side faces 12B of adjacent first underlying GaN-based compound semiconductor layers 12 come into contact with each other. In a GaN compound semiconductor crystal, the coefficient of thermal expansion in the c-axis direction is extremely smaller than the coefficient of thermal expansion of a sapphire substrate. Consequently, the seed layers 11 and the first underlying GaN-based compound semiconductor layers 12 may be detached from the sapphire substrate 10 due to a large change in temperature.

In second embodiment, in a step similar to [Step-110] in the first embodiment, first underlying GaN-based compound semiconductor layers 12 are formed by lateral epitaxial growth from seed layers 11. The lateral epitaxial growth is stopped before opposite side faces 12B of adjacent first underlying GaN-based compound semiconductor layers 12 come into contact with each other. In a step similar to [Step-130] in the first embodiment, third underlying GaN-based compound semiconductor layers 15 are formed by lateral epitaxial growth from opposite side faces 12B of adjacent first underlying GaN-based compound semiconductor layers 12 while second underlying GaN-based compound semiconductor layers 14 are formed by lateral epitaxial growth. Thus, in the step similar to [Step-110] in the first embodiment, the first underlying GaN-based compound semiconductor layers 12 and the seed layers 11 can be reliably prevented from being detached from a sapphire substrate 10 due to the difference in the coefficient of thermal expansion when the temperature of the sapphire substrate 10 is reduced in order to form mask layers 13.

A method for producing a GaN-based semiconductor light-emitting element according to the second embodiment will be described below with reference to Figs. 3A to 3D that are each a schematic partial end view of a substrate such as a sapphire substrate.

[Step-200]

The plurality of seed layers 11 that are composed of a GaN-based compound semiconductor and that are apart from each other are formed on the r-plane of the sapphire substrate 10 (see Fig. 3A) in the same way as in [Step-100] in the first embodiment.

[Step-210]

The first underlying GaN-based compound semiconductor layers 12 each having a top face 12A parallel to the a-plane and each having the side face 12B parallel to the c-plane are formed by lateral epitaxial growth from the seed layers 11 (see Fig. 3B). In the second embodiment, the first underlying GaN-based compound semiconductor layers 12 are formed by lateral epitaxial growth from the seed layers 11. The lateral epitaxial growth is stopped before opposite side faces 12B of adjacent first underlying GaN-based compound semiconductor layers 12 come into contact with each other. Specifically, the same step as [Step-110] in the first embodiment is performed, except that the film-forming time is shorter than that in the first embodiment.

[Step-220]

The mask layers 13 are formed on portions of the top faces 12A of the first underlying GaN-based compound semiconductor layers 12 above the seed layers 11 in the same way as in [Step-120] in the first embodiment (see Fig. 3C).

[Step-230]

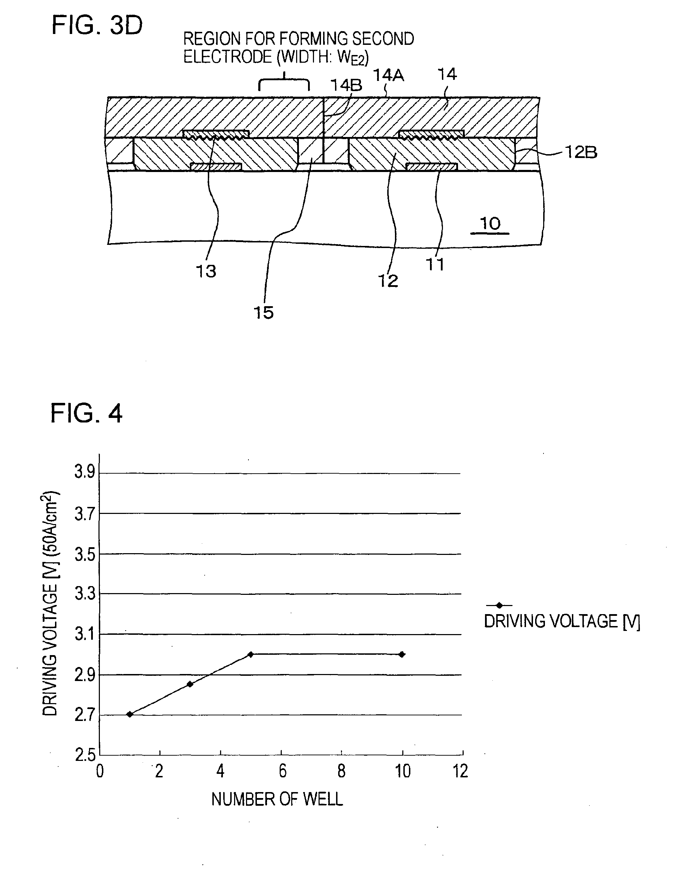

The second underlying GaN-based compound semiconductor layers 14 are formed by lateral epitaxial growth from the top faces 12A of the first underlying GaN-based compound semiconductor layers 12 in the same way as in [Step-130] in the first embodiment. The third underlying GaN-based compound semiconductor layers 15 are also formed by lateral epitaxial growth from opposite side faces 12B of adjacent first underlying GaN-based compound semiconductor layers 12 (see Fig. 3D).
Thereby, the GaN-based compound semiconductor layers can be formed.

[Step-240]

Subsequently, the same steps as [Step-140] to [Step-170] in the first embodiment are performed to obtain a GaN-based semiconductor light-emitting element.
In the second embodiment, the relationship between the number of quantum wells constituting the active layer and the driving voltage is shown in Fig. 4. Specifically, the quantum well constituting the active layer 22 is formed of an $In_YGaN_{(1-Y)}$ sublayer (Y = 0.20) having a thickness of 2.5 nm and a GaN sublayer having a thickness of 7.5 nm. As is apparent from Fig. 4, the driving voltage is increased with increasing number of quantum wells. That is, the driving voltage is 3 volt or less when the number of quantum wells is five or less. The driving voltage is slightly increased when the number of quantum wells exceeds five.
In addition, a GaN-based semiconductor light-emitting element without the contact layer 24 was produced as a second comparative embodiment. Driving voltages of the GaN-based semiconductor light-emitting elements (the quantum wells were described as above, and the number of quantum wells was three) in the second embodiment and the second comparative embodiment were measured at an electric current density of about 50 A/cm$^2$. Table 4 shows the results.
[Table 4]

| | |
|---|---|
| Second embodiment: | 2.8 volt |
| Second comparative embodiment: | 3.8 volt |

THIRD EMBODIMENT

A third embodiment is the modification of the second embodiment. A main difference between the third embodiment and the second embodiment is the film-forming conditions when the first underlying GaN-based compound semiconductor layers 12 are formed by lateral epitaxial growth from the seed layers 11. In particular, the difference is an increased flow rate of the nitrogen source gas.

[Step-300]

The plurality of seed layers 11 that are composed of a GaN-based compound semiconductor and that are apart from each other are formed on the r-plane of a sapphire substrate 10 in the same way as in [Step-100] in the first embodiment. In the third embodiment,

$$W_S = 6 \ \mu m;$$

and

$$P_S = 24 \ \mu m.$$

[Step-310]

First underlying GaN-based compound semiconductor layers 12 each having the top face 12A parallel to the m-plane and each having a side face 12B parallel to the c-plane are formed by lateral epitaxial growth from the seed layers 11 in the same way as in [Step-210] in the second embodiment. Also in the third embodiment, the first underlying GaN-based compound semiconductor layers 12 are formed by lateral epitaxial growth from the seed layers 11. The lateral epitaxial growth is stopped before opposite side faces 12B of adjacent first underlying GaN-based compound semiconductor layers 12 come into contact with each other. Specifically, the same step as [Step-110] in the first embodiment is performed, except that the film-forming time is shorter than that in the first embodiment. Under the film-forming conditions shown in Table 1, the resulting first underlying GaN-based compound semiconductor layers 12 may have a large number of point defects. In addition, a large amount of carbon in the organogallium source gas may be contained in the first underlying GaN-based compound semiconductor layers 12, thus intensifying yellow light emission. Thus, in the third embodiment, the flow rate of the nitrogen source gas shown in Table 1 was changed from 1 SLM to 2 SLM. Under the film-forming conditions for the first underlying GaN-based compound semiconductor layers 12 shown in the first embodiment, the lateral growth rate is high, and the flow rate of the nitrogen source gas is low. Thus, the first underlying GaN-based compound semiconductor layers 12 may be brown. Under the growth conditions for the first underlying GaN-based compound semiconductor layers 12 in the third embodiment, the first underlying GaN-based compound semiconductor layers 12 are not colored and are transparent. Furthermore, at 2 SLM of the flow rate of the nitrogen source gas, the lateral growth rate is relatively reduced, resulting in the tendency that opposite side faces 12B of adjacent first underlying GaN-based compound semiconductor layers 12 do not easily come into contact with each other.

[Step-320]

The mask layers 13 are formed on portions of the top faces 12A of the first underlying GaN-based compound semiconductor layers 12 above the seed layers 11 in the same way as in [Step-120] in the first embodiment. The mask layers 13 are each in the form of a strip in a plan view and each has a width $W_M$ of 9 $\mu$m. That is, in a plan view, each of the mask layers 13 is located within a corresponding one of the seed layers 11, and $W_M/W_S$ = 1.5.

[Step-330]

The second underlying GaN-based compound semiconductor layers 14 are formed by lateral epitaxial growth from the top faces 12A of the first underlying GaN-based compound semiconductor layers 12 in the same way as in [Step-130] in the first embodiment. The third underlying GaN-based compound semiconductor layers 15 are also formed by lateral epitaxial growth from opposite side faces 12B of adjacent first underlying GaN-based compound semiconductor layers 12.
Thereby, the GaN-based compound semiconductor layers can be formed.

[Step-340]

Subsequently, the same steps as [Step-140] to [Step-170] in the first embodiment are performed to obtain a GaN-based semiconductor light-emitting element.

FOURTH EMBODIMENT

A fourth embodiment relates to GaN-based semiconductor light-emitting elements according to second and third aspects of the present invention. The fourth embodiment also relates to a method for producing the GaN-based semiconductor light-emitting element according to the second aspect of the present invention. A schematic cross-sectional view of a GaN-based semiconductor light-emitting element according to the fourth embodiment, more specifically, a light-emitting diode (LED), is the same as in Fig. 1.
The GaN-based semiconductor light-emitting element according to the fourth embodiment has a structure in which a first GaN-based compound semiconductor layer 21, an active layer 22, a second GaN-based compound semiconductor layer 23, and a contact layer 24 are stacked. The top face of the first GaN-based compound semiconductor layer 21 is parallel to the m-plane or a nonpolar plane and has a first conductivity type (specifically, n-type). The active layer 22 is disposed on the first GaN-based compound semiconductor layer 21 and has the top face parallel to the m-plane or the nonpolar plane. In the fourth embodiment, the active layer has the same multiple-quantum-well structure as in the first embodiment. The second GaN-based compound semiconductor layer 23 is disposed on the active layer 22, has the top face parallel to the m-plane or the nonpolar plane, and has a second conductivity type (specifically, p-type). The Mg atomic concentration of the second GaN-based compound semiconductor layer 23 is the same as in the first embodiment.
The contact layer 24 has a thickness of 10 nm, is disposed on the second GaN-based compound semiconductor layer 23, is composed of a GaN-based compound semiconductor (specifically, $In_XGa_{(1-X)}N$, X = 0.1), and has the top face parallel to the m-plane or the nonpolar plane. The Mg atomic concentration of the contact layer 24 is the same as in the first embodiment.

Also in the fourth embodiment, a first electrode 25 is disposed on the first GaN-based compound semiconductor layer 21, and a second electrode 26 is disposed on the contact layer 24.

A method for producing the GaN-based semiconductor light-emitting element according to the fourth embodiment will be described below with reference to Figs. 2A to 2D that are each a schematic partial end view of a substrate such as a LiAlO$_2$ substrate.

[Step-400]

A plurality of seed layers 11 that are composed of a GaN-based compound semiconductor and that are apart from each other are formed on the γ-plane of a LiAlO$_2$ substrate 10 (indicated by a substrate 10 in the figure) (see Fig. 2A). Specifically, the LiAlO$_2$ substrate 10 is placed in a MOCVD apparatus. A flat GaN-based compound semiconductor layer having a thickness of about 2 μm (more specifically, the GaN layer with the top face parallel to the m-plane) is formed on the LiAlO$_2$ substrate 10 in the same way as in [Step-100] in the first embodiment. The LiAlO$_2$ substrate 10 is removed from the MOCVD apparatus. The resulting GaN-based compound semiconductor layer is patterned by lithography and RIE to form strips in a plan view, thereby forming the plurality of seed layers 11 that are apart from each other.]

[Step-410]

First underlying GaN-based compound semiconductor layers 12 each having the top face 12A parallel to the m-plane and having a side face 12B parallel to the c-plane are formed by lateral epitaxial growth from the seed layers 11, in the same way as in [Step-110] in the first embodiment (see Fig. 2B). Also in the fourth embodiment, the lateral epitaxial growth of the first underlying GaN-based compound semiconductor layers 12 is stopped when opposite side faces 12B of the first underlying GaN-based compound semiconductor layers 12 come into contact with each other. Film-forming conditions are the same as in Table 1.

[Step-420]

The LiAlO$_2$ substrate 10 is removed from the MOCVD apparatus, and mask layers 13 are formed on portions of the top faces 12A of the first underlying GaN-based compound semiconductor layers 12 above the seed layers 11, in the same way as in [Step-120] in the first embodiment (see Fig. 2C). Each mask layer 13 is in the form of a strip in a plan view and has a width $W_M$ of 16 μm. That is, each of the seed layers 11 is located within a corresponding one of the mask layers 13 in a plan view, and $W_M/W_S = 1.6$. In the case of the crystal defects in the portions of the first underlying GaN-based compound semiconductor layers 12 above the seed layers 11 are difficult to identify, the first underlying GaN-based compound semiconductor layers 12 each having a thickness of about 1 μm may be formed under film-forming conditions exemplified in Table 2.

[Step-430]

Second underlying GaN-based compound semiconductor layers 14 each having the top face 14A parallel to the m-plane and each having a side face 14B parallel to the c-plane are formed on the top faces 12A of the first underlying GaN-based compound semiconductor layers 12 and the mask layers 13 by lateral epitaxial growth from the top faces 12A of the first underlying GaN-based compound semiconductor layers 12, in the same way as in [Step-130] in the first embodiment (see Fig. 2D). Film-forming conditions are the same as in Table 1.

Thereby, the GaN-based compound semiconductor layers can be formed.

[Step-440]

In the same way as in [Step-140] in the first embodiment, The first GaN-based compound semiconductor layer 21 (specifically, for example, a Si-doped GaN layer having a thickness of about 1 μm), the active layer 22 composed of a GaN-based compound semiconductor (specifically, for example, a multiple-quantum-well structure [MQW structure] in which In$_Y$GaN$_{(1-Y)}$ sublayer having a thickness of 2 to 3 nm and a GaN sublayer having a thickness of 7 to 20 nm are stacked), the second GaN-based compound semiconductor layer 23 (specifically, for example, a Mg-doped AlGaN sublayer having a thickness of 5 to 20 nm and a Mg-doped GaN sublayer having a thickness of 100 nm), and the contact layer 24 (specifically, for example, a Mg-doped In$_X$Ga$_{(1-X)}$N layer having a thickness of 10 nm) are formed in that order by a known MOCVD on the second underlying GaN-based compound semiconductor layers 14 in the same MOCVD apparatus without a reduction in the temperature of the sapphire substrate 10 to a low temperature.

[Step-450]

The second electrode 26 is formed on the contact layer 24 in the same way as in [Step-150] in the first embodiment.

[Step-460]

In the same way as in [Step-160] in the first embodiment, a support layer is formed on the entire surface. Alternatively, a support is bonded to the entire surface. Then, the seed layers 11 and the first underlying GaN-based compound semiconductor layers 12 are detached from the LiAlO$_2$ substrate 10. Specifically, interfaces between the LiAlO$_2$ substrate 10 and the seed layers 11 and between the LiAlO$_2$ substrate 10 and the first underlying GaN-based compound semiconductor layers 12 may be irradiated with laser light, such as KrF excimer-laser light having a wavelength of 248 nm, through the LiAlO$_2$ substrate 10. Then, the seed layers 11, the first underlying GaN-based compound semiconductor layers 12, the mask layers 13, and the second underlying GaN-based compound semiconductor layers 14 are removed by a combination of etching and polishing to expose the first GaN-based compound semiconductor layer 12. The first electrode 25 is formed on the exposed first GaN-based compound semiconductor layer 21. Furthermore, a transparent electrode (not shown) composed of ITO and connected to the first electrode 25 is formed.

[Step-470]

In the same way as in [Step-170] in the first embodiment, the stacked structure including the first GaN-based compound semiconductor layer 21, the active layer 22 composed of the GaN-based compound semiconductor, the second GaN-based compound semiconductor layer 23, and the contact layer 24 is cleaved and cut to form an LED chip. Mounting is performed in such a manner that the transparent electrode is located at the top. Wiring and resin molding are performed. Thereby, a GaN semiconductor light-emitting element including a shell-shaped LED device can be obtained.

Also in the fourth embodiment, the luminescence wavelength of the LED device can be controlled in the range of 450 nm to 530 nm by adjusting the In content (Y value) of the In$_Y$Ga$_{(1-Y)}$N sublayer constituting the active layer 22.

Alternatively, in the case where the first GaN-based compound semiconductor layer 21 is an AlGaN layer, the active layer 22 is a GaN layer, an InGaN layer, or an AlInGaN layer, and the second GaN-based compound semiconductor layer 23 is an AlGaN layer, the luminescence wavelength of the LED device can be controlled in the range of 360 nm to 400 nm.

FIFTH EMBODIMENT

A fifth embodiment is the modification of the fourth embodiment. In the fifth embodiment, in a step similar to [Step-410] in the fourth embodiment, first underlying GaN-based compound semiconductor layers 12 are formed by lateral epitaxial growth from seed layers 11. The lateral epitaxial growth is stopped before opposite side faces 12B of adjacent first underlying GaN-based compound semiconductor layers 12 come into contact with each other. In a step similar to [Step-430] in the fourth embodiment, third underlying GaN-based compound semiconductor layers 15 are formed by lateral epitaxial growth from opposite side faces 12B of adjacent first underlying GaN-based compound semiconductor layers 12 while second underlying GaN-based compound semiconductor layers 14 are formed by lateral epitaxial growth.

A method for producing a GaN-based semiconductor light-emitting element according to the fifth embodiment will be described below with reference to Figs. 3A to 3D that are each a schematic partial end view of a substrate such as a LiAlO$_2$ substrate.

[Step-500]

The plurality of seed layers 11 that are composed of a GaN-based compound semiconductor and that are apart from each other are formed on the LiAlO$_2$ substrate 10 (see Fig. 3A) in the same way as in [Step-400] in the fourth embodiment.

[Step-510]

The first underlying GaN-based compound semiconductor layers 12 each having a top face 12A parallel to the m-plane and each having the side face 12B parallel to the c-plane are formed by lateral epitaxial growth from the seed layers 11, in the same way as in [Step-210] in the second embodiment (see Fig. 3B). In the fifth embodiment, the first underlying GaN-based compound semiconductor layers 12 are formed by lateral epitaxial growth from the seed layers 11. The lateral epitaxial growth is stopped before opposite side faces 12B of adjacent first underlying GaN-based compound semiconductor layers 12 come into contact with each other. Specifically, the same step as [Step-410] in the fourth embodiment is performed, except that the film-forming time is shorter than that in the fourth embodiment.

[Step-520]

The mask layers 13 are formed on portions of the top faces 12A of the first underlying GaN-based compound semiconductor layers 12 above the seed layers 11 in the same way as in [Step-420] in the fourth embodiment (see Fig. 3C).

[Step-530]

The second underlying GaN-based compound semiconductor layers 14 are formed by lateral epitaxial growth from the top faces 12A of the first underlying GaN-based compound semiconductor layers 12 in the same way as in [Step-430] in the fourth embodiment. The third underlying GaN-based compound semiconductor layers 15 are also formed by lateral epitaxial growth from opposite side faces 12B of adjacent first underlying GaN-based compound semiconductor layers 12 (see Fig. 3D).
Thereby, the GaN-based compound semiconductor layers can be formed.

[Step-540]

Subsequently, the same steps as [Step-440] to [Step-470] in the fourth embodiment are performed to obtain a GaN-based semiconductor light-emitting element.

SIXTH EMBODIMENT

A sixth embodiment is the modification of the fifth embodiment. A main difference between the sixth embodiment and the fifth embodiment is the film-forming conditions when the first underlying GaN-based compound semiconductor layers 12 are formed by lateral epitaxial growth from the seed layers 11. In particular, the difference is an increased flow rate of the nitrogen source gas.

[Step-600]

The plurality of seed layers 11 that are composed of a GaN-based compound semiconductor and that are apart from each other are formed on a $LiAlO_2$ substrate 10 in the same way as in [Step-400] in the fourth embodiment. In the sixth embodiment,

$$W_S = 6 \ \mu m;$$

and

$$P_S = 24 \ \mu m.$$

[Step-610]

First underlying GaN-based compound semiconductor layers 12 each having the top face 12A parallel to the m-plane and each having a side face 12B parallel to the c-plane are formed by lateral epitaxial growth from the seed layers 11 in the same way as in [Step-510] in the fifth embodiment. Also in the sixth embodiment, the first underlying GaN-based compound semiconductor layers 12 are formed by lateral epitaxial growth from the seed layers 11. The lateral epitaxial growth is stopped before opposite side faces 12B of adjacent first underlying GaN-based compound semiconductor layers 12 come into contact with each other. Specifically, the same step as [Step-410] in the fourth embodiment is performed, except that the film-forming time is shorter than that in the fourth embodiment. Under the film-forming conditions shown in Table 1, the resulting first underlying GaN-based compound semiconductor layers 12 may have a large number of point defects. In addition, a large amount of carbon in the organogallium source gas may be contained in the first underlying GaN-based compound semiconductor layers 12, thus intensifying yellow light emission. Thus, in the sixth embodiment, the flow rate of the nitrogen source gas shown in Table 1 was changed from 1 SLM to 2 SLM. Under the film-forming conditions for the first underlying GaN-based compound semiconductor layers 12 shown in the fourth embodiment, the lateral growth rate is high, and the flow rate of the nitrogen source gas is low. Thus, the first underlying GaN-based compound semiconductor layers 12 may be brown. Under the growth conditions for the first underlying GaN-based compound semiconductor layers 12 in the sixth embodiment, the first underlying GaN-based compound semiconductor layers 12 are not colored and are transparent. Furthermore, at 2 SLM of the flow rate of the nitrogen source gas, the lateral growth rate is relatively reduced, resulting in the tendency that opposite side faces 12B of adjacent first underlying GaN-based compound semiconductor layers 12 do not easily come into contact with each other.

[Step-620]

The mask layers 13 are formed on portions of the top faces 12A of the first underlying GaN-based compound semiconductor layers 12 above the seed layers 11 in the same way as in [Step-420] in the fourth embodiment. The mask layers 13 are each in the form of a strip in a plan view and each has a width $W_M$ of 9 $\mu$m. That is, in a plan view, each of the mask layers 13 is located within a corresponding one of the seed layers 11, and $W_M/W_S = 1.5$.

[Step-630]

The second underlying GaN-based compound semiconductor layers 14 are formed by lateral epitaxial growth from the top faces 12A of the first underlying GaN-based compound semiconductor layers 12 in the same way as in [Step-430] in the fourth embodiment. The third underlying GaN-based compound semiconductor layers 15 are also formed by lateral epitaxial growth from opposite side faces 12B of adjacent first underlying GaN-based compound semiconductor layers 12.

Thereby, the GaN-based compound semiconductor layers can be formed.

[Step-640]

Subsequently, the same steps as [Step-440] to [Step-470] in the fourth embodiment are performed to obtain a GaN-based semiconductor light-emitting element.

The present invention has been described based on the preferred embodiments. However, the present invention is not limited to these embodiments. The types, compositions, thicknesses, structures, etc., of the substrate and the GaN-based compound semiconductor layers are merely examples, and these may be changed appropriately. Furthermore, the conditions, the numerical values, and the materials used described in the embodiments are merely examples, and these may be changed appropriately.

In the case where the {11-2n} plane (a nonpolar plane at about 40° to the c-plane) is used, in steps as in the first to third embodiments, the (11-2n) plane of a bulk GaN substrate is used as a facet. Then, various GaN-based compound semiconductor layers may be grown on the facet.

In [Step-140] in the first embodiment and [Step-440] in the fourth embodiment, after the formation of the first GaN-based compound semiconductor layer 21, an $In_zGa_{(1-z)}N$ layer (z = 0.01 to 02) having a thickness of 100 nm to 300 nm may be formed in order to suppress the occurrence of piezoelectric spontaneous polarization before the formation of the active layer 22.

In the embodiments, the seed layers 11 composed of a GaN-based compound semiconductor are formed by a method including forming a GaN-based compound semiconductor layer on the substrate 10 and then patterning the GaN-based compound semiconductor layer by lithography and etching. However, the method for forming the seed layers 11 is not limited to such a method. As shown in Fig. 5 that is schematic partial end view of a substrate such as substrate 10, seed layers 111 composed of a GaN-based compound semiconductor may also be produced by forming a GaN-based compound semiconductor layer 111A (for example, the GaN layer with the top face parallel to the a-plane or the m-plane) on the substrate 10; forming a non-growing layer 111B (a layer on which a GaN compound semiconductor layer does not grow); and then patterning the non-growing layer 11B by lithography and etching to expose the GaN-based compound semiconductor layer 111A.

Furthermore, in some cases, the GaN-based semiconductor light-emitting element having the structure described in the first or fourth embodiment may also be produced by forming a buffer layer on a substrate, and forming a first GaN-based compound semiconductor layer, an active layer, a second GaN-based compound semiconductor layer, and a contact layer, in that order, on the buffer layer using a known MOCVD.

In addition, the method according to the first or second aspect of the present invention for producing a GaN-based semiconductor light-emitting element may be expressed as below. That is, a method for producing a GaN-based semiconductor light-emitting element includes the steps of:

(a) forming a plurality of seed layers on a predetermined plane of a substrate, the seed layers being composed of a GaN-based compound semiconductor and being apart from each other;

(b) forming first underlying GaN-based compound semiconductor layers by lateral epitaxial growth from seed layers, each of the first underlying GaN-based compound semiconductor layers having a top face that is parallel to a nonpolar plane;

(c) forming mask layers each disposed on a portion of the top face of a corresponding one of the first underlying GaN-based compound semiconductor layers above the seed layers;

(d) forming second underlying GaN-based compound semiconductor layers each disposed on the top face of a corresponding one of the first underlying GaN-based compound semiconductor layers and each disposed on a corresponding one of the mask layers by lateral epitaxial growth from the top faces of the first underlying GaN-based compound semiconductor layers, each of the second underlying GaN-based compound semiconductor layers having the top face that is parallel to the nonpolar plane;

(e) forming a first GaN-based compound semiconductor layer having a first conductivity type and having the top face that is parallel to the nonpolar plane on the second underlying GaN-based compound semiconductor layers;

(f) forming an active layer with the top face that is parallel to the nonpolar plane on the first GaN-based compound semiconductor layer;

(g) forming a second GaN-based compound semiconductor layer having a second conductivity type and having the top face that is parallel to the nonpolar plane on the active layer; and

(h) forming a contact layer composed of a GaN-based compound semiconductor and having the top face that is parallel to the nonpolar plane on the second GaN-based compound semiconductor layer.

**Claims**

1. A method for producing a GaN-based semiconductor light-emitting element, comprising the steps of:

(a) forming a plurality of seed layers on the r-plane of a sapphire substrate, the seed layers being composed of a GaN-based compound semiconductor and being apart from each other;

(b) forming first underlying GaN-based compound semiconductor layers by lateral epitaxial growth from seed layers, each of the first underlying GaN-based compound semiconductor layers having a top face that is parallel to the a-plane;

(c) forming mask layers each disposed on a portion of the top face of a corresponding one of the first underlying GaN-based compound semiconductor layers above the seed layers;

(d) forming second underlying GaN-based compound semiconductor layers each disposed on the top face of a corresponding one of the first underlying GaN-based compound semiconductor layers and each disposed on a corresponding one of the mask layers by lateral epitaxial growth from the top faces of the first underlying GaN-based compound semiconductor layers, each of the second underlying GaN-based compound semiconductor layers having the top face that is parallel to the a-plane;

(e) forming a first GaN-based compound semiconductor layer having a first conductivity type and having the top face that is parallel to the a-plane on the second underlying GaN-based compound semiconductor layers;

(f) forming an active layer with the top face that is parallel to the a-plane on the first GaN-based compound semiconductor layer;

(g) forming a second GaN-based compound semiconductor layer having a second conductivity type and having the top face that is parallel to the a-plane on the active layer; and

(h) forming a contact layer composed of a GaN-based compound semiconductor and having the top face that is parallel to the a-plane on the second GaN-based compound semiconductor layer.

2. The method for producing a GaN-based semiconductor light-emitting element according to claim 1, wherein in the step (b), the first underlying GaN-based compound semiconductor layers are formed by lateral epitaxial growth from the seed layers, and then the lateral epitaxial growth is stopped before opposite side faces of the first underlying GaN-based compound semiconductor layers come into contact with each other, and wherein in the step (d), third underlying GaN-based compound semiconductor layers are formed by lateral epitaxial growth from opposite side faces of the first underlying GaN-based compound semiconductor layers while the second underlying GaN-based compound semiconductor layers are formed by lateral epitaxial growth.

3. The method for producing a GaN-based semiconductor light-emitting element according to claim 1, further comprising formation of a second electrode on the contact layer after the formation of the contact layer.

4. The method for producing a GaN-based semiconductor light-emitting element according to claim 3, wherein the second electrode is located above a portion of a corresponding one of the second underlying GaN-based compound semiconductor layers disposed on the top faces of the first underlying GaN-based compound semiconductor layers.

5. The method for producing a GaN-based semiconductor light-emitting element according to claim 4, wherein in a plan view, the second electrode is within the portion of the corresponding one of the second underlying GaN-based compound semiconductor layers disposed on the top faces of the first underlying GaN-based compound semiconductor layers.

6. The method for producing a GaN-based semiconductor light-emitting element according to claim 5, wherein when the seed layers are each in the form of a strip having a width $W_S$ in a plan view, and the mask layers are each in the form of a strip having a width $W_M$ in a plan view, the following expressions are satisfied:

$$W_M/W_S \; > \; 1;$$

and

$$W_{E2}/(P_S \; - \; W_M) \; < \; 1$$

where $P_S$ represents the formation pitch of the plurality of seed layers; and $W_{E2}$ represents the width of the second electrode.

7. The method for producing a GaN-based semiconductor light-emitting element according to claim 2, further comprising detachment of the seed layers, the first underlying GaN-based compound semiconductor layers, and the third underlying GaN-based compound semiconductor layers from the r-plane of the sapphire substrate after the formation of the second GaN-based compound semiconductor layer.

8. The method for producing a GaN-based semiconductor light-emitting element according to claim 7, further comprising after the detachment of the seed layers, the first underlying GaN-based compound semiconductor layers, and the third underlying GaN-based compound semiconductor layers from the r-plane of the sapphire substrate, removal of the seed layers, the first underlying GaN-based compound semiconductor layers, the third underlying GaN-based compound semiconductor layers, the second underlying GaN-based compound semiconductor layers, and the mask layers so as to expose the first GaN-based compound semiconductor layer.

9. The method for producing a GaN-based semiconductor light-emitting element according to claim 8, further comprising formation of a first electrode on the exposed first GaN-based compound semiconductor layer.

10. The method for producing a GaN-based semiconductor light-emitting element according to claim 1, wherein the seed layers and the mask layers are each in the form of a strip in a plan view.

11. The method for producing a GaN-based semiconductor light-emitting element according to claim 10, wherein in a plan view, each seed layer is within a corresponding one of the mask layers.

12. The method for producing a GaN-based semiconductor light-emitting element according to claim 11, wherein the following expression is satisfied:

$$W_M/W_S \; > \; 1$$

where $W_S$ represents the width of each seed layer; and $W_M$ represents the width of each mask layer.

**13.** A method for producing a GaN-based semiconductor light-emitting element, comprising the steps of:

(a) forming a plurality of seed layers on a LiAlO$_2$ substrate, the seed layers being composed of a GaN-based compound semiconductor and being apart from each other;

(b) forming first underlying GaN-based compound semiconductor layers by lateral epitaxial growth from seed layers, each of the first underlying GaN-based compound semiconductor layers having a top face that is parallel to the m-plane;

(c) forming mask layers each disposed on a portion of the top face of a corresponding one of the first underlying GaN-based compound semiconductor layers above the seed layers;

(d) forming second underlying GaN-based compound semiconductor layers each disposed on the top face of a corresponding one of the first underlying GaN-based compound semiconductor layers and each disposed on a corresponding one of the mask layers by lateral epitaxial growth from the top faces of the first underlying GaN-based compound semiconductor layers, each of the second underlying GaN-based compound semiconductor layers having the top face that is parallel to the m-plane;

(e) forming a first GaN-based compound semiconductor layer having a first conductivity type and having the top face that is parallel to the m-plane on the second underlying GaN-based compound semiconductor layers;

(f) forming an active layer with the top face that is parallel to the m-plane on the first GaN-based compound semiconductor layer;

(g) forming a second GaN-based compound semiconductor layer having a second conductivity type and having the top face that is parallel to the m-plane on the active layer; and

(h) forming a contact layer composed of a GaN-based compound semiconductor and having the top face that is parallel to the m-plane on the second GaN-based compound semiconductor layer.

**14.** The method for producing a GaN-based semiconductor light-emitting element according to claim 13, wherein in the step (b), the first underlying GaN-based compound semiconductor layers are formed by lateral epitaxial growth from the seed layers, and then the lateral epitaxial growth is stopped before opposite side faces of the first underlying GaN-based compound semiconductor layers come into contact with each other, and wherein in the step (d), third underlying GaN-based compound semiconductor layers are formed by lateral epitaxial growth from opposite side faces of the first underlying GaN-based compound semiconductor layers while the second underlying GaN-based compound semiconductor layers are formed by lateral epitaxial growth.

**15.** The method for producing a GaN-based semiconductor light-emitting element according to claim 13, further comprising formation of a second electrode on the contact layer after the formation of the contact layer.

**16.** The method for producing a GaN-based semiconductor light-emitting element according to claim 15, wherein the second electrode is located above a portion of a corresponding one of the second underlying GaN-based compound semiconductor layers disposed on the top faces of the first underlying GaN-based compound semiconductor layers.

**17.** The method for producing a GaN-based semiconductor light-emitting element according to claim 16, wherein in a plan view, the second electrode is within the portion of the corresponding one of the second underlying GaN-based compound semiconductor layers disposed on the top faces of the first underlying GaN-based compound semiconductor layers.

**18.** The method for producing a GaN-based semiconductor light-emitting element according to claim 17, wherein when the seed layers are each in the form of a strip having a width $W_S$ in a plan view, and the mask layers are each in the form of a strip having a width $W_M$ in a plan view, the following expressions are satisfied:

$$W_M/W_S > 1;$$

and

$$W_{E2}/(P_S - W_M) < 1$$

where $P_S$ represents the formation pitch of the plurality of seed layers; and $W_{E2}$ represents the width of the second electrode.

19. The method for producing a GaN-based semiconductor light-emitting element according to claim 14, further comprising detachment of the seed layers, the first underlying GaN-based compound semiconductor layers, and the third underlying GaN-based compound semiconductor layers from the LiAlO$_2$ substrate after the formation of the second GaN-based compound semiconductor layer.

20. The method for producing a GaN-based semiconductor light-emitting element according to claim 19, further comprising after the detachment of the seed layers, the first underlying GaN-based compound semiconductor layers, and the third underlying GaN-based compound semiconductor layers from the LiAlO$_2$ substrate, removal of the seed layers, the first underlying GaN-based compound semiconductor layers, the third underlying GaN-based compound semiconductor layers, the second underlying GaN-based compound semiconductor layers, and the mask layers so as to expose the first GaN-based compound semiconductor layer.

21. The method for producing a GaN-based semiconductor light-emitting element according to claim 20, further comprising formation of a first electrode on the exposed first GaN-based compound semiconductor layer.

22. A GaN-based semiconductor light-emitting element comprising:

    (A) a first GaN-based compound semiconductor layer having a first conductivity type and having a top face that is parallel to the a-plane;
    (B) an active layer disposed on the first GaN-based compound semiconductor layer, the active layer having the top face that is parallel to the a-plane;
    (C) a second GaN-based compound semiconductor layer disposed on the active layer, the second GaN-based compound semiconductor layer having a second conductivity type and having the top face that is parallel to the a-plane;
    (D) a first electrode disposed on the first GaN-based compound semiconductor layer;
    (E) a second electrode; and
    (F) a contact layer disposed between the second GaN-based compound semiconductor layer and the second electrode, the contact layer being composed of a GaN-based compound semiconductor and having the top face that is parallel to the a-plane.

23. A GaN-based semiconductor light-emitting element comprising:

    (A) a first GaN-based compound semiconductor layer having a first conductivity type and having a top face that is parallel to the m-plane;
    (B) an active layer disposed on the first GaN-based compound semiconductor layer, the active layer having the top face that is parallel to the m-plane;
    (C) a second GaN-based compound semiconductor layer disposed on the active layer, the second GaN-based compound semiconductor layer having a second conductivity type and having the top face that is parallel to the m-plane;
    (D) a first electrode disposed on the first GaN-based compound semiconductor layer;
    (E) a second electrode; and
    (F) a contact layer disposed between the second GaN-based compound semiconductor layer and the second electrode, the contact layer being composed of a GaN-based compound semiconductor and having the top face that is parallel to the m-plane.

24. A GaN-based semiconductor light-emitting element comprising:

    (A) a first GaN-based compound semiconductor layer having a first conductivity type and having a top face that is parallel to a nonpolar plane;
    (B) an active layer disposed on the first GaN-based compound semiconductor layer, the active layer having the top face that is parallel to the nonpolar plane;
    (C) a second GaN-based compound semiconductor layer disposed on the active layer, the second GaN-based compound semiconductor layer having a second conductivity type and having the top face that is parallel to the nonpolar plane;
    (D) a first electrode disposed on the first GaN-based compound semiconductor layer;
    (E) a second electrode; and

(F) a contact layer disposed between the second GaN-based compound semiconductor layer and the second electrode, the contact layer being composed of a GaN-based compound semiconductor and having the top face that is parallel to the nonpolar plane.

# FIG. 1

# FIG. 2A

# FIG. 2B

# FIG. 2C

FIG. 2D

REGION FOR FORMING SECOND
ELECTRODE (WIDTH: $W_{E2}$)

14B   14A   14

10

13   12   11

FIG. 3A

11

10

$W_S$

$P_S$

FIG. 3B

11   12A   12B   12

10

FIG. 3C

12A   $W_M$

11   13   12B   12

10

## FIG. 3D

REGION FOR FORMING SECOND
ELECTRODE (WIDTH: $W_{E2}$)

14B  14A  14

12B

10

13

15

12  11

## FIG. 4

DRIVING VOLTAGE [V] (50A/cm²)

NUMBER OF WELL

DRIVING VOLTAGE [V]

# FIG. 5

# FIG. 6A

C-PLANE {0001}

A-PLANE {11$\bar{2}$0}

M-PLANE {1$\bar{1}$00}

## FIG. 6B

R-PLANE {1$\bar{1}$02}

## FIG. 6C

{11$\bar{2}$4} PLANE

# FIG. 6D

S-PLANE {1$\bar{1}$01}

## INTERNATIONAL SEARCH REPORT

| International application No. |
|---|
| PCT/JP2005/023760 |

A. CLASSIFICATION OF SUBJECT MATTER
*H01L33/00*(2006.01)

According to International Patent Classification (IPC) or to both national classification and IPC

B. FIELDS SEARCHED

Minimum documentation searched (classification system followed by classification symbols)
*H01L33/00*(2006.01)

Documentation searched other than minimum documentation to the extent that such documents are included in the fields searched

| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-46127 A  (Sanyo Electric Co., Ltd.),<br>14 February, 2003 (14.02.03),<br>Par. Nos. [0027] to [0188]; Figs. 1 to 14<br>(Family: none) | 22-24<br>1,3-13,15-21 |
| X<br>Y | JP 2004-111514 A  (Sanyo Electric Co., Ltd.),<br>08 April, 2004 (08.04.04),<br>Par. Nos. [0023] to [0052], [0093] to [0134];<br>Figs. 1 to 3, 16 to 18<br>(Family: none) | 22-24<br>1,3-13,15-21 |
| X<br>Y | JP 2004-335559 A  (Nichia Chemical Industries,<br>Ltd.),<br>25 November, 2004 (25.11.04),<br>Full text; all drawings<br>(Family: none) | 22-24<br>1,3-13,15-21 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>09 February, 2006 (09.02.06) | Date of mailing of the international search report<br>21 February, 2006 (21.02.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| | International application No. |
|---|---|
| | PCT/JP2005/023760 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2001-274518 A (Fuji Photo Film Co., Ltd.), 05 October, 2001 (05.10.01), Full text; all drawings (Family: none) | 1,3-13,15-21 |
| Y | JP 2002-33282 A (Nichia Chemical Industries, Ltd.), 31 January, 2002 (31.01.02), Par. Nos. [0041] to [0053], [0065] to [0079] (Family: none) | 1,3-13,15-21 |
| Y | JP 2004-262757 A (Sony Corp.), 24 September, 2004 (24.09.04), Par. No. [0101]; Fig. 20 & US 2003/0020087 A1 | 4,6,16,18 |
| Y | JP 2003-37286 A (Matsushita Electric Industrial Co., Ltd.), 07 February, 2003 (07.02.03), Par. Nos. [0067] to [0078]; Fig. 4 & US 6750158 B2        & EP 1258913 A2 | 7-9,19-21 |
| Y | P. Waltereit etc, 'Nitride semiconductors free of electrostatic fields for efficient white light-emitting diodes', "letters to nature", NATURE, 24 August, 2000 (24.08.00), Vol.406, pages 865 to 868 | 13-21 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003158294 A

- JP 2002100579 A